# EUROPEAN PATENT APPLICATION

(11) **EP 1 351 253 A1**
(43) Date of publication of application: **08.10.2003**
(21) Application number: 03252043.9
(22) Date of filing: 31.03.2003
(51) Int. Cl.: G11C 17/14

(54) **Memory structures**

(30) Priority: 02.04.2002 US 115750
(71) Applicant: Hewlett-Packard Company, Palo Alto, CA 94304 (US)
(72) Inventor: Fricke, Peter, Crovallis, OR 97330 (US); Koll, Andrew, Albany, OR 97321 (US); Lazaroff, Dennis M., Corvallis, OR 97330 (US); Van Brocklin, Andrew L., Corvallis, OR 97330 (US)
(74) Representative: Jackson, Richard Eric

(57) **Abstract**

A memory structure that includes a first electrode (835, 235, 335, 435, 535, 635, 743), a second electrode (27, 239a, 239b, 339a, 339b, 439a, 439b, 539a, 539b, 639a, 639b, 735) having an edge, a third electrode (833, 233, 333, 341, 433, 441, 533, 633, 641, 739), a control element (25) disposed between the first electrode and the second electrode, and memory storage element (23) disposed between the edge of the second electrode and the third electrode.

## Description

### BACKGROUND OF THE DISCLOSURE

As computer and other electrical equipment continue to drop in price, the manufacturers of storage devices, such as memory devices and hard drives, are forced to lower the cost of their components. At the same time, computer, video game, television and other electrical device markets are requiring increasingly larger amounts of memory to store images, photographs, videos, movies, music and other storage intensive data. Thus, besides reducing cost, manufacturers of storage devices must also increase the storage density of their devices. This trend of increasing memory storage density while reducing cost required to create the storage has been on-going for many years, and even optical storage such as CD-ROM, CD-R, CD-R/W, DVD, and DVD-R variants are being challenged by device size limitations and cost. There is accordingly a need for economical, high capacity memory structures.

### BRIEF DESCRIPTION OF THE DRAWINGS

The features and advantages of the disclosure will readily be appreciated by persons skilled in the art from the following detailed description when read in conjunction with the drawing wherein:
FIG. 1 is a schematic diagram of an embodiment of a cross-point memory array in which the disclosed memory cell structures can be utilized.
FIG. 2 is a schematic block diagram of an embodiment of a memory cell that includes a memory storage element and a control element for the memory storage element.
FIGS. 3 and 4 are sectional views that schematically depict an embodiment of a memory structure that includes a memory storage element disposed between a rim edge of a conductive tub and a conductive line.
FIG. 5 is a sectional view and FIG. 6 is a plan view that schematically depict an embodiment of a memory structure that includes a memory storage element disposed between an edge of a conductive plate and a conductive pillar.
FIG. 7 is a sectional view and FIG. 8 is a plan view that schematically depict an embodiment of a memory structure that includes a memory storage element disposed between an edge of a conductive plate and a conductive well.
FIG. 9 is a sectional view and FIG. 10 is a plan view that schematically depict an embodiment of a memory structure that includes a memory storage element disposed between an edge of a conductive plate and a conductive well.
FIG. 11 is a sectional view and FIG. 12 is a plan view that schematically depict an embodiment of a memory structure that includes a memory storage element disposed between an edge of a conductive plate and a conductive pillar.
FIG. 13 is a sectional view and FIG. 14 is a plan view that schematically depict an embodiment of a memory structure that includes a memory storage element disposed between an edge of a conductive plate and a conductive well.
FIG. 15 is a sectional view and FIG. 16 is a plan view that schematically depict an embodiment of a memory structure that includes a memory storage element disposed between a rim edge of a truncated conductive cone and a conductive conductive cap.
FIG. 17 is a schematic block diagram of an embodiment of a memory carrier that incorporates at least one of the disclosed memory cells.
FIG. 18 is a schematic block diagram of an embodiment of an electronic device, such as a computer system, that incorporates at least one of the disclosed memory cells.
FIG. 19 is a flow diagram of an embodiment of the basic steps that can be used to implement the disclosed memory structures.FIG. 18 is a schematic block diagram of an embodiment of an electronic device, such as a computer system, that incorporates at least one of the disclosed memory cells.

### DETAILED DESCRIPTION OF THE DISCLOSURE

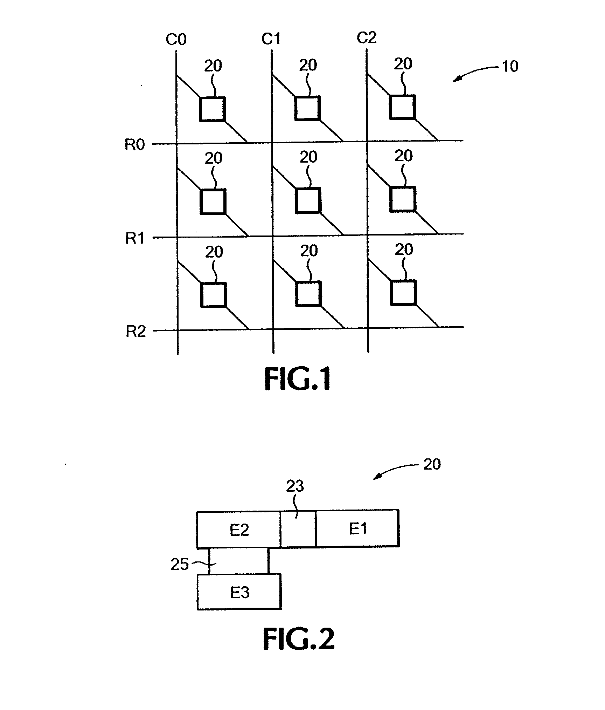

FIG. 1 is a simplified schematic diagram of an embodiment of a cross-point memory array 10 in which the disclosed memory cell structures can be utilized. The memory arrangement 10 includes row selection conductor lines R0, R1, R2 and column selection conductor lines C0, C1, C2. A memory cell 20 is connected between each row selection conductor line R0, R1, R2 and each column selection conductor line C0, C1, C2. It should be appreciated that the row selection conductor lines and the column selection conductor lines are referred to by "row" and "column" terminology for convenience, and that in actual implementations the memory cells 20 do not necessarily have to be physically arranged in rows and columns. Each memory cell is basically uniquely accessed or selected by a first selection line and a second selection line that can be oriented in different ways. Also, the column lines do not have to be orthogonal to the row lines, but are illustrated in that manner for ease of understanding.

FIG. 2 is a simplified electrical block diagram of an embodiment of the memory cell 20 which includes a memory storage element 23 that is electrically connected to a control element 25 by an electrode E2. The memory storage element 23 and the control element 25 are serially connected between an electrode E1 and an electrode E3. The electrodes E1-E3 comprise conductive elements such as conductors, conductive regions or other conductive features, and it should be appreciated that the electrode E2 can comprise one or more electrically conductive elements.

The memory storage element is more particularly configured to predictably and reliably break down at a lower energy level than the control element, while the control tunnel junction region is more particularly configured for sustained operation as a control element for the memory. Thus, the memory storage element 23 changes state at a lower energy level than the control element 25, which allows the memory storage element to be programmed. In this manner, a memory cell is programmed by selectively providing sufficient energy to the cell to cause the memory storage element to break down. A memory cell is read by providing a lesser amount of energy to the memory cell and sensing whether current flows through the cell.

The memory storage element 23 can be an antifuse device, such as a programmable tunnel junction device. The antifuse device can be either a dielectric rupture type device or a tunnel junction device. The tunnel junction can be formed from oxidized metal, thermally grown oxide, or deposited oxides or nitrides. The memory storage element may also be embodied with semiconductor materials such as polysilicon, polycrystalline silicon, amorphous silicon, microcrystalline silicon, metal filament electro migration, trap induced hysterisis, ferroelectric capacitor, Hall effect, and polysilicon resistors. Other embodiments of the memory storage element include tunneling magneto-resistive or capacitive elements as floating gates. Still further, the memory storage element can be a read only LeComber or silicide switch or a re-writable phase-change material. The memory storage element can also comprise a PIN diode or a Schottky diode.

The control element 25 can comprise a tunnel junction device or PN, PIN or Schottky diodes. Other diodes that can be used include Zener diodes, avalanche diodes, tunnel diodes, and a four layer diode such as a silicon controlled rectifier. Also, the control element 25 can be a junction field effect or bipolar transistor. The control element 25 is sized sufficiently to carry an adequate current such that the state of the storage element 23 can be changed. When the control element is a diode, it can be formed using doped polysilicon, amorphous silicon, or microcrystalline silicon.

For ease of discussion, the disclosed memory structures are described, by way of illustrative examples, as employing tunnel junction devices as the memory storage elements and control elements, and it should be appreciated that the memory storage elements and control elements can be implemented as described above.

Also by way of illustrative examples, the disclosed memory structures are depicted as integrated circuits that include interlayer dielectric such as silicon dioxide, silicon nitride, or TEOS (tetraethylorthosilicate) that provide support and isolation between various structures of an integrated circuit. The ILD can be deposited using several different technologies such as chemical vapor deposition (CVD), atmospheric pressure CVD, low pressure CVD, plasma enhanced CVD, physical vapor deposition (PVD), and sputtering. For convenience, regions and layers of such dielectric are identified in the drawings by the reference designation ILD.

In the disclosed memory structures, the memory storage element 23 is disposed adjacent to an edge of a conductor.

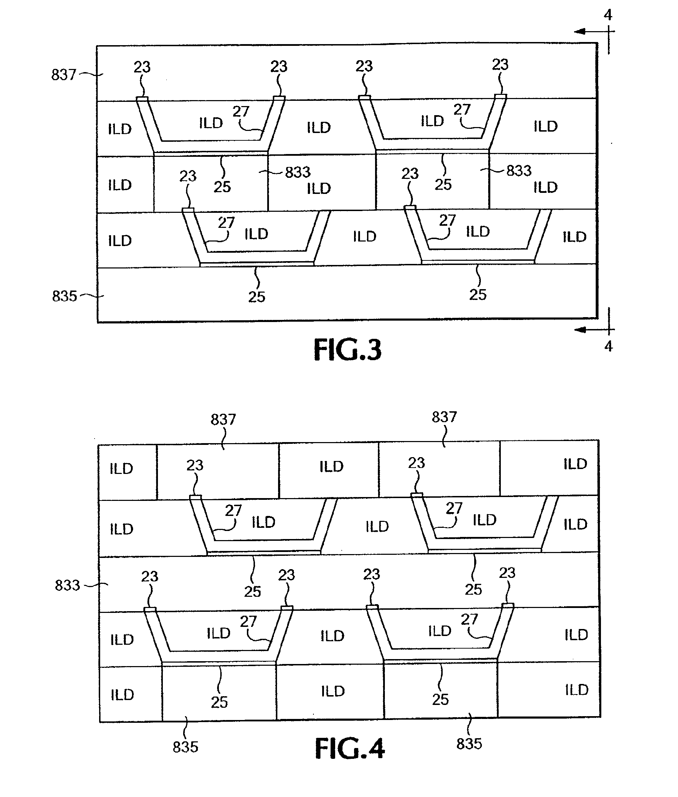

FIGS. 3 and 4 schematically depict an embodiment of a memory structure that includes a plurality of memory cells each including a memory storage element 23 disposed between the rim edge of a conductive well or tub 27 and a conductor 833 or 837 that is vertically adjacent the rim edge. Each memory cell further includes a control element 25 disposed between the base of the conductive tub 27 and a conductor 833 or 835 that is vertically adjacent the base. The memory storage element 23 and/or the control element 25 can have a horizontally planar extent, and are vertically separated.

The memory cells of FIGS. 3 and 4 can be implemented in stacked layers for example wherein a conductor 833 that is vertically adjacent the rim edge of a given conductive tub 27 is vertically adjacent the base of a conductive tub 27 that is in an adjacent layer.

By way of illustrative example, the conductor 833 can be a row selection line while the conductors 835, 837 can be column selection lines in a cross-point memory structure. Also by way of illustrative example, a conductive tub 27 can be laterally offset relative to the conductor 833 that is vertically adjacent the rim of such conductive tub 27, for example to control the area of the memory tunnel junction oxide region 23. As a result, a conductive tub 27 is laterally offset relative to another vertically adjacent conductive tub 27 in an adjacent layer.

The memory storage element 23 can formed of an oxide of the conductive tub 27, and the control element 25 can be formed of an oxide of the conductor 833 or 835 that is vertically adjacent the base of the conductive tub 27. Alternatively, the memory tunnel junction oxide region 23 can be formed of an oxide that is different from an oxide of the rim of the conductive tub 27, and the control tunnel junction oxide region 25 can be formed of an oxide that is different from an oxide of the conductor 833 or 835. The memory storage element 23 can also be a portion of an unpatterned oxide layer that can be a deposited oxide layer or a completely oxidized deposited metal layer, for example. Similarly, the control element 25 can be a portion of an unpatterned oxide layer that can be a deposited oxide layer or a completely oxidized deposited metal layer, for example.

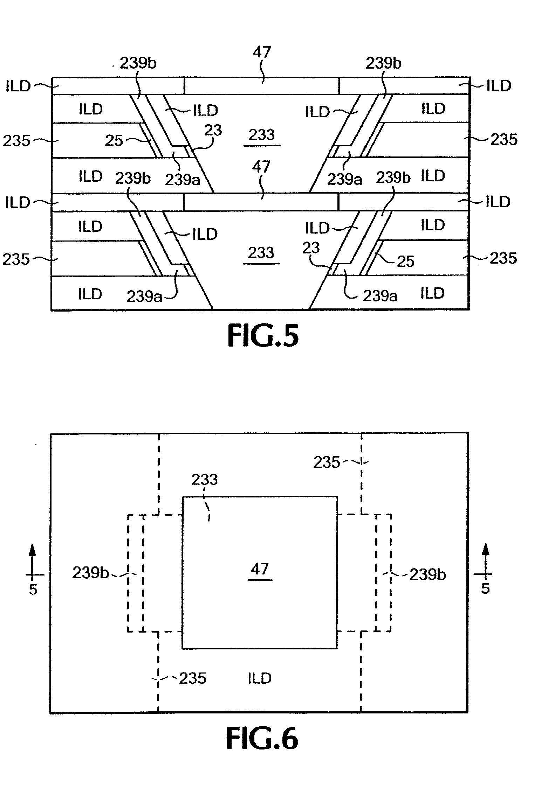

FIGS. 5 and 6 schematically depict an embodiment of a memory structure that includes memory cells each including a memory storage element 23 disposed between a conductive via or pillar 233 and an edge of a horizontal conductive plate 239a. A non-horizontal conductive panel 239b is connected to and laterally adjacent the horizontal conductive plate 239a, and a control element 25 is disposed between a face of the non-horizontal conductive panel 239b and a conductor 235 that is laterally adjacent the non-horizontal conductive panel 239b. A via cap 47 comprising for example gold or titanium nitride is disposed on the top of the conductive pillar 233.

As shown in FIGS. 5 and 6, memory cells can be formed on opposite sides of a conductive pillar 233. Also, the memory cells can be formed in layers wherein a layer includes horizontally arranged conductive pillars 233 and memory cells, and wherein the layers are stacked so that corresponding conductive pillars 233 of different layers are stacked to form columns of conductive pillars 233. The columns of conductive pillars 233 can be vertical memory selection lines of a cubic memory structure, while the conductors 235 can be row memory selection lines. In a cubic memory structure, row and column memory selection lines are arranged in a 3-D structure, for example as disclosed in commonly assigned, co-pending U.S. application Serial No. , filed concurrently herewith on , attorney docket number 10018288.

The memory storage element 23 can be formed of an oxide of the laterally contiguous horizontal plate 239a while the control element 25 can be formed of an oxide of the laterally contiguous conductor 235. Alternatively, the memory storage element 23 can be formed of an oxide that is different from an oxide of the horizontal plate 239a, and the control element 25 can be formed of an oxide that is different from an oxide of the conductor 235. The memory storage element 23 can also be a portion of an unpatterned oxide layer that can be a deposited oxide layer or a completely oxidized deposited metal layer, for example. Similarly, the control element 25 can be a portion of an unpatterned oxide layer that can be a deposited oxide layer or a completely oxidized deposited metal layer, for example.

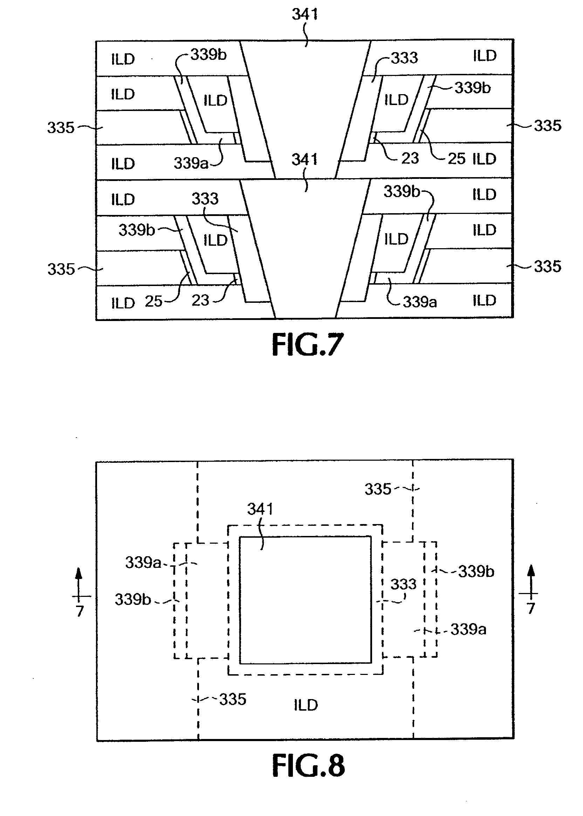

FIGS. 7 and 8 schematically depict an embodiment of a memory structure that includes memory cells each including a memory storage element 23 disposed between a conductive tub 333 and an edge of a horizontal conductive plate 339a. A non-horizontal conductive panel 339b is connected to and laterally adjacent the horizontal conductive plate 339a, and a control element 25 is disposed between a face of the non-horizontal conductive panel 339b and a conductor 335 that is laterally adjacent the non-horizontal conductive panel 339b. A vertical conductive via or pillar 341 is nested in the interior of the conductive tub 333 and passes through an aperture in the base of the conductive tub 333. The conductive pillar 341 and the conductive tub 333 form a conductive structure having a vertical extent.

As shown in FIGS. 7 and 8, memory cells can be formed on opposite sides of a conductive tub 333. Also, the memory cells can be formed in layers wherein a layer includes horizontally arranged conductive pillars 341 and memory cells, and wherein the layers are stacked so that corresponding conductive pillars 341 of different layers are stacked to form columns of conductive pillars 341. The columns of conductive pillars 341 can be vertical memory selection lines of a cubic memory structure, while the conductors 335 can be row memory selection lines.

The memory storage element 23 can be formed of an oxide of the laterally contiguous horizontal plate 339a while the control element 25 can be formed of an oxide of the laterally contiguous conductor 335. Alternatively, the memory storage element 23 can be formed of an oxide that is different from an oxide of the horizontal plate 339a, and the control element 25 can be formed of an oxide that is different from an oxide of the conductor 335. The memory storage element 23 can also be a portion of an unpatterned oxide layer that can be a deposited oxide layer or a completely oxidized deposited metal layer, for example. Similarly, the control element 25 can be a portion of an unpatterned oxide layer that can be a deposited oxide layer or a completely oxidized deposited metal layer, for example.

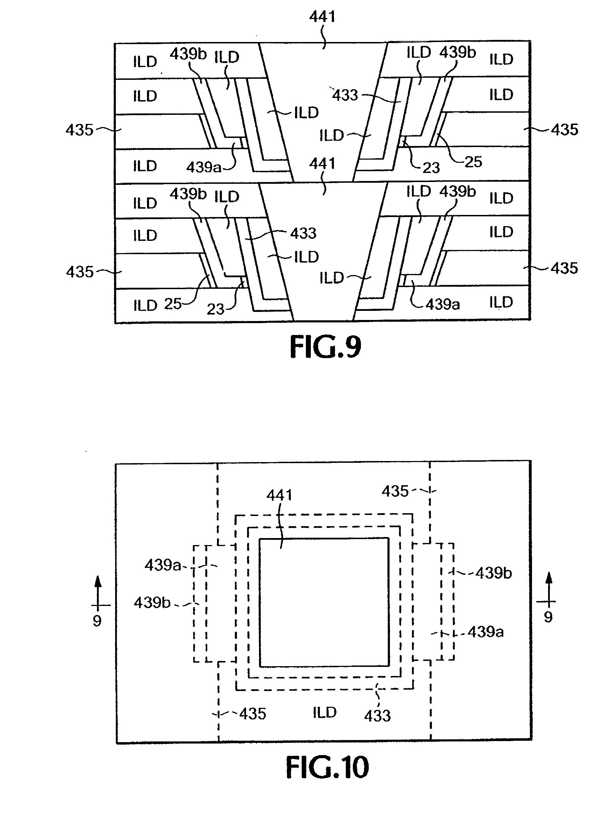

FIGS. 9 and 10 schematically depict an embodiment of a memory structure that includes memory cells each including a memory storage element 23 disposed between a conductive tub 433 and an edge of a horizontal conductive plate 439a. A non-horizontal conductive panel 439b is connected to and laterally adjacent the horizontal conductive plate 439a, and a control element 25 is disposed between a face of the non-horizontal conductive panel 439b and a conductor 435 that is laterally adjacent the non-horizontal conductive panel 439b. A conductive via or pillar 441 is nested in the interior of the conductive tub 433 and passes through an aperture in the base of the conductive tub 433. The conductive pillar 441 and the conductive tub 433 form a conductive structure having a vertical extent.

As shown in FIGS. 9 and 10, memory cells can be formed on opposite sides of a conductive tub 433. Also, the memory cells can be formed in layers wherein a layer includes horizontally arranged conductive pillars 441 and memory cells, and wherein the layers are stacked so that corresponding conductive pillars 441 of different layers are stacked to form columns of conductive pillars 441. The columns of conductive pillars 441 can be vertical memory selection lines of a cubic memory structure, while the conductors 435 can be row memory selection lines.

The memory storage element 23 can be formed of an oxide of the laterally contiguous horizontal plate 439a while the control element 25 can be formed of an oxide of the laterally contiguous conductor 435. The memory storage element 23 can be formed of an oxide that is different from an oxide of the horizontal plate 439a, and the control element 25 can be formed of an oxide that is different from an oxide of the conductor 435. The memory storage element 23 can also be a portion of an unpatterned oxide layer that can be a deposited oxide layer or a completely oxidized deposited metal layer, for example. Similarly, the control element 25 can be a portion of an unpatterned oxide layer that can be a deposited oxide layer or a completely oxidized deposited metal layer, for example.

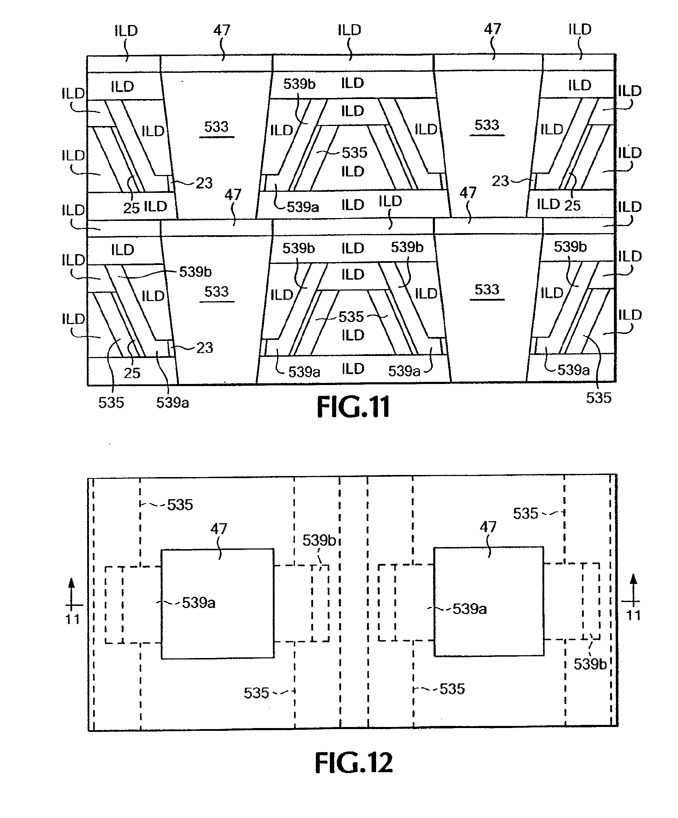

FIGS. 11 and 12 schematically depict an embodiment of a memory structure that includes memory cells each including a memory storage element 23 disposed between a vertical conductive via or pillar 533 and an edge of a horizontal conductive plate 539a. A non-horizontal conductive panel 539b is connected to and laterally adjacent the horizontal plate 539a, and a control element 25 is disposed between a face of the panel 539b and a face of a horizontally elongated conductive wall 535 that has a vertical extent and is laterally and laminarly adjacent the panel 539b. A via cap 47 comprising for example gold or titanium nitride is disposed on the top of the conductive pillar 533.

As shown in FIGS. 11 and 12, memory cells can be formed on opposite sides of a conductive pillar 533. Also, memory cells can be formed on laterally opposite sides of a region defined by adjacent elongated walls 535 that extend horizontally in the same direction. Further, the memory cells can be formed in layers wherein a layer includes horizontally arranged conductive pillars 533 and memory cells, and wherein the layers are stacked so that corresponding conductive pillars 533 of different layers are stacked to form columns of conductive pillars 533. The columns of conductive pillars 533 can be vertical memory selection lines of a cubic memory structure, while the elongated conductive walls 535 can be row memory selection lines.

The memory storage element 23 can be formed of an oxide of the laterally contiguous horizontal plate 539a while the control element 25 can be formed of an oxide of the laterally contiguous conductor 535. Alternatively, the memory storage element 23 can be formed of an oxide that is different from an oxide of the horizontal plate 539a, and the control element 25 can be formed of an oxide that is different from an oxide of the elongated conductive wall 535. The memory storage element 23 can also be a portion of an unpatterned oxide layer that can be a deposited oxide layer or a completely oxidized deposited metal layer, for example. Similarly, the control element 25 can be a portion of an unpatterned oxide layer that can be a deposited oxide layer or a completely oxidized deposited metal layer, for example.

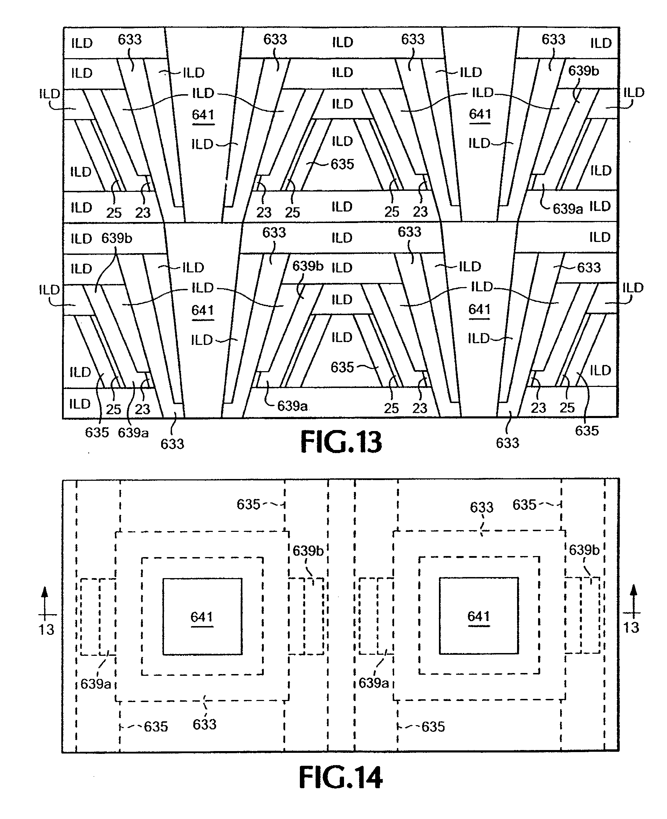

FIGS. 13 and 14 schematically depict an embodiment of a memory structure that includes memory cells each including a memory storage element 23 disposed between a conductive well or tub 633 and an edge of a horizontal conductive plate 639a. A non-horizontal conductive panel 639b is connected to and laterally adjacent the horizontal conductive plate 639a, and a control element 25 is disposed between a face of the non-horizontal conductive panel 639b and a face of an elongated conductive wall 635 that has a vertical extent and is laterally and laminarly adjacent the non-horizontal conductive panel 639b. A vertical conductive via or pillar 641 is disposed in the conductive tub 633 and contacts the tub at an opening in the base of the conductive tub, for example. The conductive pillar 641 and the conductive tub 633 form a conductive structure having a vertical extent.

As shown in FIGS. 13 and 14, memory cells can be formed on opposite sides of a conductive tub 633. Also, the memory cells can be formed in layers wherein a layer includes horizontally arranged conductive tubs 633 and memory cells, and wherein the layers are stacked so that corresponding conductive pillars 641 of different layers are stacked to form columns of conductive pillars 641. The columns of conductive pillars 641 can be vertical memory selection lines of a cubic memory structure, while the elongated conductive walls 635 can be row memory selection lines.

The memory storage element 23 can be formed of an oxide of the laterally contiguous horizontal plate 639a while the control element 25 can be formed of an oxide of the laterally contiguous conductor 635. Alternatively, the memory storage element 23 can be formed of an oxide that is different from an oxide of the horizontal plate 639a, and the control element 25 can be formed of an oxide that is different from an oxide of the elongated conductive wall 635. The memory storage element 23 can also be a portion of an unpatterned oxide layer that can be a deposited oxide layer or a completely oxidized deposited metal layer, for example. Similarly, the control element 25 can be a portion of an unpatterned oxide layer that can be a deposited oxide layer or a completely oxidized deposited metal layer, for example.

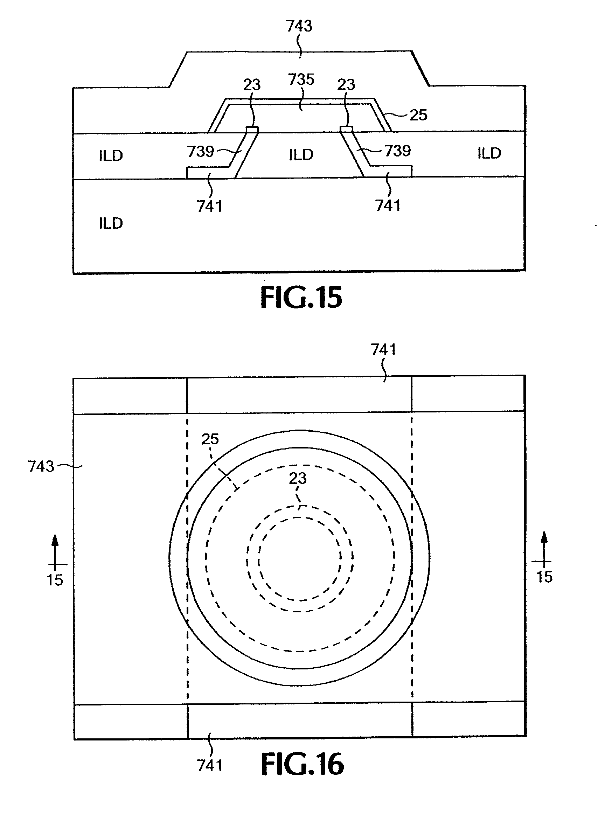

FIGS. 15 and 16 schematically depict an embodiment of a memory structure that includes memory cells each including a memory storage element 23 is disposed between a rim or edge of a conductive truncated cone 739 and a conductive cap 735. The truncated cone 739 is connected to an elongated conductor 741 that can be a memory selection line. A control element 25 is disposed between the conductive cap 735 and an elongated conductor 743 that overlies the conductive cap 735. The elongated conductor 743 can be a further memory selection line.

The memory storage element 23 can be formed of an oxide of the conductive truncated cone 739 while the control element 25 can be formed of an oxide of the conductive cap 735. Alternatively, the memory storage element 23 can be formed of an oxide that is different from an oxide of the truncated cone 739, and the control element 25 can be formed of an oxide that is different from an oxide of the conductive cap 735. The memory storage element 23 can also be a portion of an unpatterned oxide layer that can be a deposited oxide layer or a completely oxidized deposited metal layer, for example. Similarly, the control element 25 can be a portion of an unpatterned oxide layer that can be a deposited oxide layer or a completely oxidized deposited metal layer, for example.

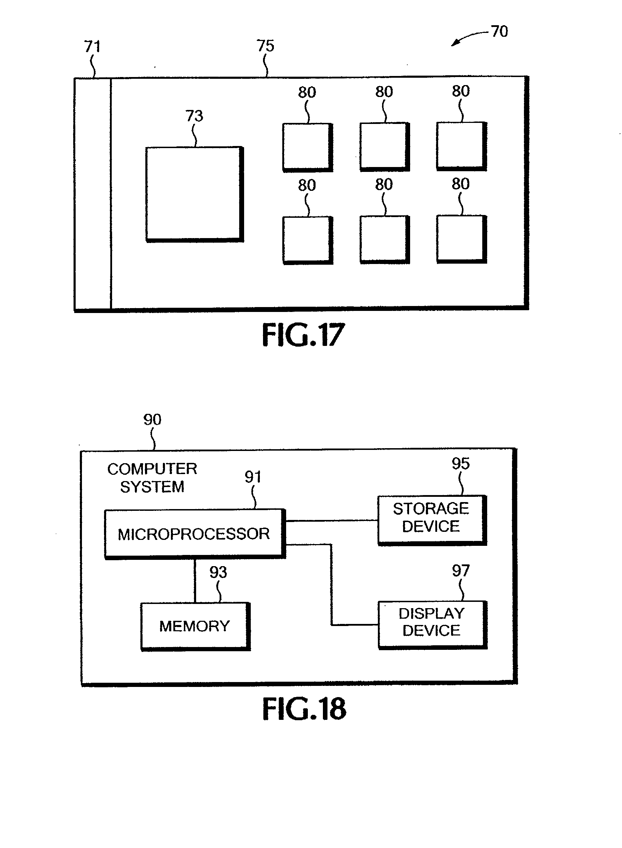

FIG. 17 is a block diagram of an embodiment of a memory carrier 70 that incorporates at least one embodiment of the invention. The memory carrier represents any of standard or proprietary memory card formats such as PCMCIA, PC card, Smart memory, Memory Stick, digital film, ATA, and compact flash, to name a few. The memory carrier 70 includes a mechanical interface 71 that provides for mechanical and electrical connection with a particular connector for the type of memory carrier implemented. An optional electrical interface 73 makes electrical coupling with the electrical contacts on the mechanical connector 71 and provides for example security, address decoding, voltage translation, write protection, or other typical interface functions with a set of memory ICs 80 that incorporate at least one embodiment of the invention. A carrier 75, for example a printed circuit board or ceramic substrate, typically is used to physically support the memory ICs 80, electrical interface 73, and mechanical interface 71. It will be appreciated by those skilled in the art that some electrical devices might incorporate the functionality of the electrical interface 73, thereby obviating its need in the memory carrier 70.

FIG. 18 is a block diagram of an embodiment of an electronic device, in this example a computer system 90, that incorporates at least one embodiment of the invention. In particular for a computer system, several different electrical devices as shown may be incorporated into the package. For example, a microprocessor 91 is coupled to a memory circuit 93 used to store computer executable instructions and/or user data. Exemplary memory circuits 93 include BIOS memory, random access memory (RAM), read only memory (ROM), and various levels of internal or external cache memory. The microprocessor 91 is also connected to a storage device 95 such as a hard disk drive, floppy drive, CD/DVD drive, tape drive or other mass storage devices such as those that incorporate semiconductor memory ICs that utilize the invention. The microprocessor 91 can include an internal cache memory that uses the invention. The memory 93 may also include memory ICs that use the invention. The microprocessor is further connected to a display device 97 that can also incorporate memory ICs that utilize the invention. The electronic device can also be configured to accept the memory carrier 70 of FIG. 17.

The disclosed memory structures can be implemented using semiconductor equipment. For example, the conductors can be formed by deposition of a metal layer followed by patterning by photolithographic masking and etching. Dielectric regions can be formed by deposition of dielectric material, while oxide layers can be formed by deposition of an oxide, deposition of a metal followed by oxidation of the deposited metal, or oxidation of a metal feature. Chemical mechanical polishing (CMP) can be employed to planarize and/or expose desired regions. Also, damascene processes such as dual damascene can be employed. In dual damascene processes, ILD is etched, metal is deposited on the etched ILD, and CMP is performed.

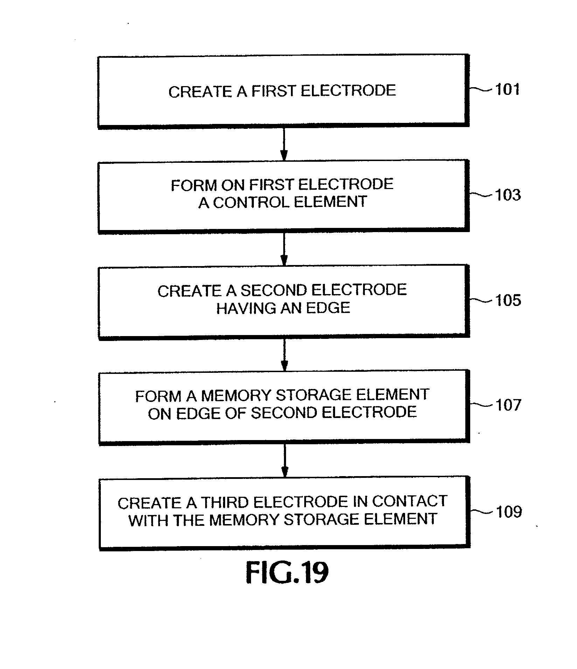

Referring now to FIG. 19, the disclosed structures can generally be made as follows. At 101 a first electrode is created for example by depositing and patterning a metal layer. At 103 a control element is formed on the first electrode, for example by oxidizing the electrode or forming an unpatterned oxide layer as described above. At 105 a second electrode having an edge is created, for example by depositing and patterning a metal layer. At 107 a memory storage element is formed on the edge of the second electrode, for example by oxidizing the electrode or forming an unpatterned oxide layer as described above. At 109 a third electrode is created. The creation of the second electrode having an edge and formation of the memory storage element can be performed prior to formation of the first electrode and formation of the control element.

Although the foregoing has been a description and illustration of specific embodiments of the invention, various modifications and changes thereto can be made by persons skilled in the art without departing from the scope and spirit of the invention as defined by the following claims.

## Claims

1. A memory structure comprising:
a first electrode (835, 235, 335, 435, 535, 635, 743);
a second electrode (27, 239a, 239b, 339a, 339b, 439a, 439b, 539a, 539b, 639a, 639b, 735) having an edge;
a third electrode (833, 233, 333, 341, 433, 441, 533, 633, 641, 739);
a memory storage element disposed between said third electrode and said edge of said second electrode; and
a control element disposed between said second electrode and said first electrode.

2. The memory structure of claim 1 wherein said third electrode comprises a conductive structure having a vertical extent.

3. The memory structure of claim 1 wherein said third electrode comprises a conductive tub.

4. The memory structure of claim 1 wherein said third electrode comprises a conductive pillar.

5. The memory structure of claim 1 wherein said third electrode comprises a truncated conductive cone having a rim edge.

6. The memory structure of claim 1 wherein said second electrode comprises a conductive plate having an edge.

7. The memory structure of claim 1 wherein said second electrode comprises a conductive tub having a rim edge.

8. The memory structure of claims 1, 2, 3, 4, 5, 6 or 7 wherein said memory storage element comprises a tunnel junction device.

9. The memory structure of claims 1, 2, 3, 4, 5, 6 or 7 wherein said memory storage element comprises an oxide of said second electrode.

10. The memory structure of claims 1, 2, 3, 4, 5, 6 or 7 wherein said memory storage element comprises an oxide that is different from an oxide of said second electrode.

11. The memory structure of claim 1, 2, 3, 4, 5, 6 or 7 wherein said memory storage element is selected from the group consisting of an antifuse, a fuse, a charge storage device, a resistive material, a trap-induced hysteresis material, a ferroelectric capacitor material, a Hall effect material, and a tunneling magneto-resistive material.

12. The memory structure of claim 1, 2, 3, 4, 5, 6 or 7 wherein said memory storage element comprises a re-writable phase change material.

13. The memory structure of claim 1, 2, 3, 4, 5, 6 or 7 wherein said control element comprises a tunnel junction device.

14. The memory structure of claim 1, 2, 3, 4, 5, 6 or 7 wherein said control element comprises an oxide of said first electrode.

15. The memory structure of claim 1, 2, 3, 4, 5, 6 or 7 wherein said control element comprises an oxide that is different from an oxide of said first electrode.

16. A memory carrier including the memory structure of claims 1, 2, 3, 4, 5, 6 or 7.

17. An electronic device configured to receive the memory carrier of claim 16.

18. An electronic device including the memory structure of claims 1, 2, 3, 4, 5, 6 or 7.

19. A method of making a memory structure comprising:
creating a first electrode;
forming a control element on the first electrode;
creating a second electrode having an edge;
forming memory storage element on the second electrode; and
creating a third electrode in contact with the memory storage element.

20. A method of making a memory structure comprising:
creating a first electrode having an edge;
forming a memory storage element on the edge of the first electrode;
creating a second electrode in contact with the memory storage element;
forming a control element on the second electrode;
forming a third electrode in contact with the control element.
